# EUROPEAN PATENT APPLICATION

(11) **EP 4 718 971 A1**
(43) Date of publication of application: **01.04.2026**
(21) Application number: 24838324.2
(22) Date of filing: 11.03.2024
(51) Int. Cl.: H10B 53/30

(54) **MEMORY AND PREPARATION METHOD THEREFOR, AND ELECTRONIC DEVICE**

(30) Priority: 07.07.2023 CN 202310834326
(71) Applicant: Huawei Technologies Co., Ltd., Shenzhen, Guangdong 518129 (CN)
(72) Inventor: YIN, Shihui, Shenzhen, Guangdong 518129 (CN); JING, Weiliang, Shenzhen, Guangdong 518129 (CN); JI, Bingwu, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Pfenning, Meinig & Partner mbB
(86) International application number: PCT/CN2024/080935
(87) International publication number: WO 2025/011063

(57) **Abstract**

This application discloses a memory and a preparation method thereof, and an electronic device, and relates to the field of semiconductor storage technologies. The memory includes a substrate, a plurality of memory arrays, a filling structure, and an isolation spacer. The memory array includes a plurality of memory cells, the memory cells include a transistor and at least one capacitor that are stacked, and the at least one capacitor is electrically connected to a side that is of the transistor and that is away from the substrate. In a direction parallel to the substrate, the filling structure is located between transistors of two adjacent memory arrays. The isolation spacer is located on a side that is of the filling structure and that is away from the substrate, and in the direction parallel to the substrate, located between capacitors of the two adjacent memory arrays. The filling structure is disposed to increase structure density of a region between adjacent memory arrays. In this way, during a preparation process, a process defect of a film layer structure in an edge region of the memory array can be mitigated, thereby mitigating a performance degradation phenomenon of a transistor in the edge region of the memory array.

## Description

This application claims priority to Chinese Patent Application No. 202310834326.3, filed with the China National Intellectual Property Administration on July 7, 2023 and entitled "MEMORY AND PREPARATION METHOD THEREOF, AND ELECTRONIC DEVICE", which is incorporated herein by reference in its entirety.

### TECHNICAL FIELD

This application relates to the field of semiconductor storage technologies, and in particular, to a memory and a preparation method thereof, and an electronic device.

### BACKGROUND

With explosive development of information, higher storage density is a development direction of storage technologies, to obtain a higher storage capacity. As a result, a three-dimensional (3-dimensional, 3D) memory merges. The three-dimensional memory usually includes a plurality of memory arrays for storing data, and the memory arrays are stacked in a direction perpendicular to a substrate to form a 3D structure. The memory array may include a plurality of memory cells, and each memory cell includes a metal-oxide-semiconductor field-effect transistor (metal-oxide-semiconductor field-effect transistor, MOSFET) and at least one capacitor electrically connected to the transistor. However, in a memory cell located at an edge of a memory array in a related technology, a transistor is prone to performance degradation.

### SUMMARY

Embodiments of this application provide a memory and a preparation method thereof, and an electronic device, to mitigate a phenomenon that a transistor in a memory cell located at an edge of a memory array is prone to performance degradation.

To achieve the foregoing objective, the following technical solutions are used in embodiments of this application.

According to a first aspect, a memory is provided. The memory includes a substrate, a plurality of memory arrays, a filling structure, an insulating portion, and an isolation spacer. The plurality of memory arrays are located on the substrate, the memory array includes a plurality of memory cells, the memory cell includes a transistor and at least one capacitor that are stacked in a first direction, the at least one capacitor is electrically connected to a side that is of the transistor and that is away from the substrate, and the first direction is perpendicular to the substrate. The filling structure is located on the substrate, and in a direction parallel to the substrate, the filling structure is located between transistors of two adjacent memory arrays. The isolation spacer is located on a side that is of the filling structure and that is away from the substrate, and in the direction parallel to the substrate, the isolation spacer is located between capacitors of the two adjacent memory arrays.

During preparation of the memory array, processes such as etching (Etch) and chemical mechanical polishing (Chemical Mechanical Polishing, CMP) are required to prepare the transistor. It may be understood that structures of the transistors of the plurality of memory arrays need to be synchronously prepared by using these processes. Because there is a great difference between structure density of an isolation region and structure density of an edge region, during the foregoing preparation process, a process defect may occur in a film layer structure located in the edge region (for example, the film layer structure is dented and deformed), resulting in performance degradation of a transistor located in the edge region. Herein, the "isolation region" refers to a region located between adjacent memory arrays, and the "edge region" refers to a region located at an edge of the memory array. Herein, the "structure density" refers to a quantity of transistors in a unit area of such region. Herein, the "performance degradation" refers to a phenomenon like an excessively high off-state current of the transistor.

The filling structure is disposed between the two adjacent memory arrays, to increase structure density of the isolation region, thereby reducing a difference between the structure density of the edge region of the memory array and the structure density of the isolation region. In this way, during the preparation process, the process defect of the film layer structure in the edge region of the memory array can be mitigated, thereby mitigating a performance degradation phenomenon of the transistor in the edge region of the memory array.

In some implementations, the filling structure includes a virtual transistor, at least a part of the virtual transistor and at least a part of the transistor are disposed at a same layer, and the virtual transistor and the transistor are spaced from each other. This helps simplify a preparation process of the filling structure, improves preparation efficiency of the memory, and reduces preparation costs of the memory. In addition, a dielectric portion of a conducting wire and a second electrode of the virtual transistor are disposed at a same layer, so that the virtual transistor does not have a control function. This helps prevent the virtual transistor from interfering with another transistor, and helps improve performance of the memory array.

In some implementations, a first electrode of the transistor and a second electrode of the transistor are disposed in the first direction, the first electrode of the transistor is electrically connected to the at least one capacitor, a channel layer of the transistor is located between the first electrode of the transistor and the second electrode of the transistor, and a gate of the transistor surrounds the channel layer of the transistor. A first electrode of the virtual transistor and a second electrode of the virtual transistor are disposed in the first direction, the first electrode of the virtual transistor is connected to the isolation spacer, a channel layer of the virtual transistor is located between the first electrode of the virtual transistor and the second electrode of the virtual transistor, and a gate of the transistor surrounds the channel layer of the transistor. The first electrode of the transistor and the first electrode of the virtual transistor are disposed at a same layer, the channel layer of the transistor and the channel layer of the virtual transistor are disposed at a same layer, and the gate of the transistor and the gate of the virtual transistor are disposed at a same layer. This helps simplify the preparation process of the filling structure, improves the preparation efficiency of the memory, and reduces the preparation costs of the memory.

In some implementations, the plurality of memory cells are spaced from each other in a second direction, the plurality of memory cells are spaced from each other in a third direction, the second direction and the third direction are both perpendicular to the first direction, and the second direction intersects with third direction. The memory further includes a plurality of conducting wires that are spaced from each other in the third direction, an extension direction of the conducting wire is parallel to the second direction, the conducting wire includes a plurality of conducting portions and a plurality of dielectric portions, the conducting portions and the dielectric portions are alternately disposed in the second direction, the conducting portion and the second electrode of the transistor are disposed at a same layer and in contact, and the dielectric portion and the second electrode of the virtual transistor are disposed at a same layer and in contact. The memory further includes a plurality of bit lines that are spaced from each other in the third direction, the bit line is located between the conducting wire and the substrate, an extension direction of the bit line is parallel to the second direction, and the bit line is electrically connected to the conducting portion of the conducting wire. This helps simplify preparation processes of the transistor and the virtual transistor, and can improve the preparation efficiency of the memory and reduce the preparation costs of the memory. In addition, the virtual transistor does not have the control function. This helps prevent the virtual transistor from interfering with another transistor, and helps improve the performance of the memory array.

In some implementations, the plurality of memory cells are spaced from each other in the second direction, the plurality of memory cells are spaced from each other in the third direction, the second direction and the third direction are both perpendicular to the first direction, and the second direction intersects with the third direction. There are a plurality of virtual transistors between the two adjacent memory arrays, the plurality of virtual transistors are spaced from each other in the third direction, and the virtual transistors and a plurality of transistors arranged in the second direction are spaced from each other in the second direction. This can increase structure density of transistors in each row of the isolation region, helps further reduce the difference between the structure density of the edge region of the memory array and the structure density of the isolation region. In this way, the process defect of the film layer structure in each row of the edge region of the memory array is mitigated, thereby further mitigating the performance degradation phenomenon of the transistor in the edge region of the memory array.

In some implementations, a row of virtual transistors arranged in the third direction constitute a virtual transistor group, there are a plurality of virtual transistor groups between the two adjacent memory arrays, and the plurality of virtual transistor groups are spaced from each other in the second direction. Increasing a quantity of virtual transistor groups helps further increase the structure density of transistors in each row of the edge region of the memory array, further reduce the difference between the structure density of the edge region of the memory array and the structure density of the isolation region. In this way, the process defect of the film layer structure in each row of the edge region of the memory array is mitigated, thereby further mitigating the performance degradation phenomenon of the transistor in the edge region of the memory array.

In some implementations, a distance between the virtual transistor and the transistor that are arranged in the second direction and that are adjacent to each other is equal to a distance between two transistors that are arranged in the second direction and that are adjacent to each other. This helps further reduce the difference between the structure density of the edge region of the memory array and the structure density of the isolation region. In this way, the process defect of the film layer structure in each row of the edge region of the memory array is mitigated, thereby further mitigating the performance degradation phenomenon of the transistor in the edge region of the memory array.

In some implementations, a distance between two virtual transistors that are arranged in the second direction and that are adjacent to each other is equal to the distance between the two transistors that are arranged in the second direction and that are adjacent to each other. This helps further reduce the difference between the structure density of the edge region of the memory array and the structure density of the isolation region. In this way, the process defect of the film layer structure in each row of the edge region of the memory array is mitigated, thereby further mitigating the performance degradation phenomenon of the transistor in the edge region of the memory array. In addition, this further helps increase arrangement normalization of the virtual transistors and the transistors.

In some implementations, the memory further includes a plurality of word lines that are spaced from each other in the second direction, an extension direction of the word line is parallel to the third direction, at least one word line is electrically connected to gates of a row of transistors arranged in the third direction, and at least one word line is electrically connected to gates of a row of virtual transistors arranged in the third direction. This helps simplify the preparation processes of the transistor and the virtual transistor, improves the preparation efficiency of the memory, and reduces the preparation costs of the memory.

In some implementations, the filling structure includes a support block, and a material of the support block includes an insulating material. In this way, the film layer structure of the support block is simple, which helps improve normalization of the filling structure, and further improves a function of the support block to provide mechanical support and/or load balancing. In addition, the material of the support block is set to the insulating material, which further helps avoid interference caused by the support block to another transistor, and helps improve the performance of the memory array.

In some implementations, the memory further includes the insulating portion, the insulating portion is located between the filling structure and the memory array, the insulating portion is further located between the isolation spacer and the memory array, and the insulating portion and the filling structure are made of different materials. Herein, the "different materials" means that at least a part of film layers of the insulating portion and the filling structure are made of different materials. For example, all the film layers of the insulating portion and the filling structure are made of different materials, or a part of the film layers of the insulating portion and the filling structure are made of different materials. In this way, the insulating portion can implement isolation effect between the isolation spacer and the memory array, and can further implement isolation effect between the filling structure and the memory array.

In some implementations, the capacitor is a ferroelectric capacitor. In this way, the memory is a ferroelectric memory, and the ferroelectric memory is characterized by non-volatile storage of data and a high access rate.

According to a second aspect, a memory preparation method is further provided. The preparation method includes: providing a substrate; forming a plurality of memory arrays and a filling structure, where the plurality of memory arrays and the filling structure are all located on the substrate, the memory array includes a plurality of memory cells, the memory cell includes a transistor and at least one capacitor that are stacked in a first direction, the at least one capacitor is electrically connected to a side that is of the transistor and that is away from the substrate, the first direction is perpendicular to the substrate, and the filling structure is located between two adjacent memory arrays; and forming an isolation spacer, where the isolation spacer is located on a side that is of the filling structure and that is away from the substrate, and located between the two adjacent memory arrays.

In some implementations, after providing the substrate and before forming the plurality of memory arrays and the filling structure, the preparation method further includes: forming a plurality of bit lines that are spaced from each other in a third direction and a plurality of intermediate conducting wires that are spaced from each other in the third direction, where the intermediate conducting wire is located on a side that is of the bit line and that is away from the substrate, extension directions of the bit line and the intermediate conducting wire are parallel to a second direction, the second direction and the third direction are both perpendicular to the first direction, and the second direction intersects with the third direction; removing a part of the intermediate conducting wires to form a plurality of grooves that are spaced from each other, where the intermediate conducting wire between adjacent grooves constitutes a conducting portion; forming a dielectric portion in the groove, where a plurality of dielectric portions and a plurality of conducting portions that are alternately disposed in the second direction constitute a conducting wire; and forming a plurality of word lines that are spaced from each other in the second direction, where the word line is located on a side that is of the conducting wire and that is away from the substrate, and an extension direction of the word line is parallel to the third direction. The filling structure is disposed between the two adjacent memory arrays, to increase structure density of the isolation region, thereby reducing a difference between the structure density of the edge region of the memory array and the structure density of the isolation region. In this way, during the preparation process, the process defect of the film layer structure in the edge region of the memory array can be mitigated, thereby mitigating a performance degradation phenomenon of the transistor in the edge region of the memory array.

In some implementations, the filling structure includes a virtual transistor. When the plurality of conducting portions are formed, a second electrode of the transistor is further formed. When the dielectric portion is formed in the groove, a second electrode of the virtual transistor is further formed. When the plurality of word lines that are spaced from each other in the second direction are formed, a metal gate of the transistor and a metal gate of the virtual transistor are further formed. In this way, the metal gate of the transistor and the metal gate of the virtual transistor are disposed at a same layer.

In some implementations, after forming the plurality of word lines that are spaced from each other in the second direction, forming the plurality of memory arrays and the filling structure further includes: forming a first channel hole and a second channel hole that pass through the word line; filling the first channel hole and the second channel hole with a gate medium material and a channel material, to form a gate medium layer of the transistor and a channel layer of the transistor in the first channel hole, and form a gate medium layer of the virtual transistor and a channel layer of the virtual transistor in the second channel hole, where the metal gate of the transistor and the gate medium layer of the transistor constitute a gate of the transistor, a gate of the transistor surrounds the channel layer of the transistor, the metal gate of the virtual transistor and the gate medium layer of the virtual transistor constitute the gate of the virtual transistor, and the gate of the virtual transistor surrounds the channel layer of the virtual transistor; and forming a first electrode of the transistor and a first electrode of the virtual transistor, where the first electrode of the transistor is located on a side that is of the channel layer of the transistor and that is away from the substrate, and the first electrode of the virtual transistor is located on a side that is of the channel layer of the virtual transistor and that is away from the substrate. In this way, the virtual transistor and the transistor are partially disposed at the same layer.

In some implementations, after the gate of the transistor and the gate of the virtual transistor are formed, forming the plurality of memory arrays further includes: forming a plurality of dielectric layers and a plurality of conducting layers that are alternately stacked; forming a through hole that passes through the plurality of dielectric layers and the plurality of conducting layers; and sequentially filling the through hole with a capacitor material and an electrode material, to form a capacitor layer and a capacitor electrode in the through hole, where the capacitor layer is located between the capacitor electrode and a side wall of the through hole, the capacitor electrode is a shared second capacitor electrode of a plurality of capacitors, and at least a part of the conducting layers that surround a periphery of the capacitor layer is a first capacitor electrode of the capacitor. In this way, at least one capacitor is formed, and the plurality of capacitors are stacked.

In some implementations, after forming the plurality of dielectric layers and the plurality of conducting layers that are alternately stacked, forming the isolation spacer includes: forming a filling space that passes through the plurality of dielectric layers and the plurality of conducting layers; and filling the filling space with an isolation material to form the isolation spacer. In this way, the isolation spacer is formed to ensure at least partial electrical isolation between adjacent memory arrays.

According to a third aspect, an electronic device is provided. The electronic device includes: a processor; and the memory according to any one of implementations of the first aspect, or the memory prepared by using the memory preparation method according to any one of implementations of the second aspect. The memory is electrically connected to the processor.

For technical effect brought by any one of the designs in the third aspect, refer to the technical effect brought by different designs in the first aspect. Details are not described herein again.

### BRIEF DESCRIPTION OF DRAWINGS

FIG. 1 is a diagram of an example of an architecture of an electronic device according to an embodiment of this application;
FIG. 2 is a diagram of an example of a structure of a memory according to an embodiment of this application;
FIG. 3a is a diagram of a structure of a memory array based on a 1TnC structure;
FIG. 3b is a diagram of a structure of a memory array arranged in a honeycomb structure based on a plurality of bit cells;
FIG. 4 is a diagram of a circuit structure of a memory cell in a memory array based on a 1TnC structure;
FIG. 5 is a read timing diagram of a memory cell in a memory array based on a 1TnC structure;
FIG. 6 is a diagram of an example of a structure of a connection of a plurality of memory arrays in a memory according to some embodiments;
FIG. 7 is a diagram of an example of a structure of a memory according to some embodiments;
FIG. 8 is a diagram of an example of a structure of another memory according to some embodiments;
FIG. 9 is a diagram of an example of a structure of another memory according to an embodiment of this application;
FIG. 10 is a diagram of an example of a structure of another memory according to an embodiment of this application;
FIG. 11a is a top view of an example of a memory in which a capacitor and an isolation spacer are omitted according to an embodiment of this application;
FIG. 11b is a top view of an example of another memory in which a capacitor and an isolation spacer are omitted according to an embodiment of this application;
FIG. 12 is a diagram of a structure of the transistor of the memory in FIG. 10;
FIG. 13 is a diagram of a structure of the virtual transistor of the memory in FIG. 10;
FIG. 14 is a flowchart of an example of steps of a memory preparation method according to an embodiment of this application;
FIG. 15 is a diagram of an example of a structure of forming an intermediate conducting wire in a memory preparation method according to an embodiment of this application;
FIG. 16 is a diagram of an example of a structure of removing a part of intermediate conducting wires in a memory preparation method according to an embodiment of this application;
FIG. 17 is a diagram of an example of a structure of forming a dielectric portion in a memory preparation method according to an embodiment of this application;
FIG. 18 is a diagram of an example of a structure of forming an insulating portion in a memory preparation method according to an embodiment of this application;
FIG. 19 is a diagram of an example of a structure of forming a first channel hole and a second channel hole in a memory preparation method according to an embodiment of this application;
FIG. 20 is a diagram of an example of a structure of forming a transistor and a virtual transistor in a memory preparation method according to an embodiment of this application;
FIG. 21 is a diagram of an example of a structure of forming a conducting layer and a dielectric layer in a memory preparation method according to an embodiment of this application;
FIG. 22 is a diagram of an example of a structure of forming a through hole in a memory preparation method according to an embodiment of this application;
FIG. 23 is a diagram of an example of a structure of forming a capacitor in a memory preparation method according to an embodiment of this application;
FIG. 24 is a diagram of an example of a structure of forming a filling space in a memory preparation method according to an embodiment of this application; and
FIG. 25 is a diagram of an example of a structure of forming an isolation spacer in a memory preparation method according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms such as "first" and "second", below are merely for convenience of description, and are not to be construed as indicating or implying relative importance or implicitly indicating a quantity of indicated technical features. Therefore, a feature limited by "first", "second", or the like may explicitly or implicitly include one or more features. In the descriptions of this application, unless otherwise stated, "a plurality of" means two or more than two.

In embodiments of this application, the word "exemplary" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the term such as "example" or "for example" is intended to present a relative concept in a specific manner.

In descriptions of some embodiments, expressions of "connected", "electrically connected", and their extensions may be used. For example, in descriptions of some embodiments, the term "connected" may indicate that two or more components are in direct physical contact with each other, and the term "electrically connected" may indicate that two or more components are in electrical contact with each other.

In addition, the use of "based on" means openness and inclusiveness, since processes, steps, computing, or other actions "based on" one or more of conditions or values in practice may be based on additional conditions or values outside the described values.

In the content of this application, the meanings of "on", "above", and "on the top of" should be interpreted in a broadest manner, so that "on" means not only "directly on something", but also includes the meaning of "on something" with an intermediate feature or layer between associated objects, and "above" or "on the top of" not only means "above" or "on the top of" something, but also includes the meaning of being "above" or "on the top of" something (that is, directly on something) without an intermediate feature or layer between the associated objects.

In this embodiment of this application, "disposed at a same layer" means that a film layer for forming a specific pattern is formed by using a same film forming process, and then a layer structure is formed by using a same mask and by using a one-time patterning process, where the layer structure is made of a same material. Based on different particular patterns, the one-time patterning process may include a plurality of exposure, development, or etching processes. Moreover, the particular patterns in the formed layer structure may be continuous or discontinuous, and these particular patterns may also have different heights or different thicknesses.

Example implementations are described herein with reference to a sectional view and/or a plane view of the accompanying drawings as idealized example drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending characteristic. Therefore, the regions shown in the accompanying drawings are essentially examples, and their shapes are not intended to show actual shapes of regions of a device, and are not intended to limit a scope of the example implementations.

Embodiments of this application provide an electronic device. The electronic device may be different types of user equipment or terminal devices, for example, a mobile phone (mobile phone), a tablet computer (pad), a personal digital assistant (personal digital assistant, PDA), a television, an intelligent wearable product (for example, a smartwatch or a smart band), a virtual reality (virtual reality, VR) terminal device, an augmented reality (augmented reality, AR) terminal device, a charging small household appliance (for example, a soybean milk machine or a robotic vacuum cleaner), an unmanned aerial vehicle, a radar, an aerospace device, and a vehicle-mounted device. The electronic device may alternatively be a network device like a base station. A specific form of the electronic device is not specifically limited in this embodiment of this application.

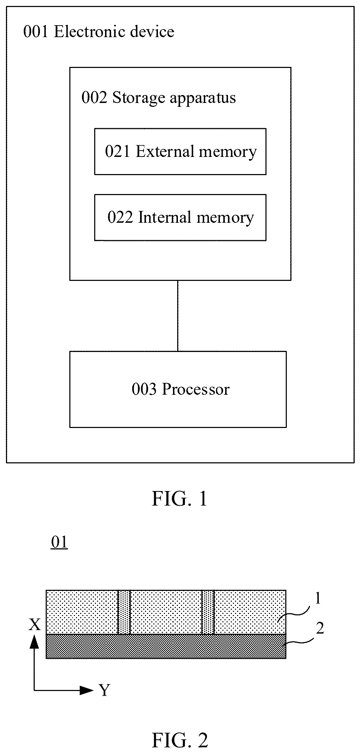

FIG. 1 is a diagram of an example of an architecture of an electronic device 001 according to an embodiment of this application. As shown in FIG. 1, the electronic device 001 includes components such as a storage apparatus 002 and a processor 003. A person skilled in the art may understand that a structure of the electronic device 001 shown in FIG. 1 does not constitute any limitation on the electronic device 001, and the electronic device 001 may include more or fewer components than those shown in FIG. 1, or may combine some of the components shown in FIG. 1, or may have a different component arrangement from that shown in FIG. 1.

The storage apparatus 002 may be configured to store a software program and a module. The storage apparatus 002 mainly includes a program storage area and a data storage area. The program storage area may store an operating system, an application program required by an at least one function (for example, a sound playing function and an image playing function), and the like. The data storage area may store data (for example, audio data, image data, and a phone book) created based on use of the electronic device 001, and the like. In addition, the storage apparatus 002 includes an external memory 021 and an internal memory 022. Data stored in the external memory 021 and the internal memory 022 may be transmitted to each other. The external memory 021 may include, for example, a hard disk, a USB flash drive, and a floppy disk. The internal memory 022 includes, for example, a random access memory or a read only memory. The random access memory may include, for example, a ferroelectric memory (ferroelectric random access memory, FeRAM), a phase change memory, or a magnetic memory.

The processor 003, as a control center of the electronic device 001, is connected to all parts of the entire electronic device 001 through various interfaces and lines, and performs various functions and data processing of the electronic device 001 by running or executing the software program and/or the module stored in the storage apparatus 002 and invoking data stored in the storage apparatus 002. In this way, overall monitoring is performed on the electronic device 001. Optionally, the processor 003 may include one or more processing units. For example, the processor 003 may include an application processor (application processor, AP), a modem processor, and a graphics processing unit (graphics processing unit, GPU). Different processing units may be independent components, or may be integrated into one or more processors 003. For example, the processor 003 may integrate the application processor and the modem processor. The application processor mainly processes an operating system, a user interface, an application, and the like. The modem processor mainly processes wireless communication. It may be understood that the foregoing modem processor may not be integrated into the processor 003. The application processor 003 may be, for example, a central processing unit (central processing unit, CPU).

FIG. 2 is a diagram of an example of a structure of a memory 01 according to an embodiment of this application. The memory 01 may be used as an internal memory 022, for example, a ferroelectric memory. The following uses an example in which the memory 01 is a three-dimensional ferroelectric capacitance (ferroelectric capacitance, FeCAP) memory (three-dimensional ferroelectric memory) for description.

As shown in FIG. 2, in this embodiment of this application, the memory 01 may include a substrate 2 and a plurality of memory arrays 1 located on the substrate 2. For ease of description, in the following, a direction perpendicular to the substrate 2 is referred to as a first direction X, both a second direction Y and a third direction Z are perpendicular to the first direction X, and the second direction Y intersects with the third direction Z. The following merely uses an example in which the second direction Y and the third direction Z are perpendicular to each other for description.

In some embodiments, the plurality of memory arrays 1 may be spaced from each other in the second direction Y or the third direction Z, so that the plurality of memory arrays 1 form a memory array layer, and the memory array layer is parallel to the substrate. In some other embodiments, the plurality of memory arrays 1 may further be spaced from each other in the first direction X, that is, a plurality of memory array layers can be formed, and the plurality of memory array layers are stacked in the first direction X. The following merely uses an example in which the memory 01 includes one memory array layer for description.

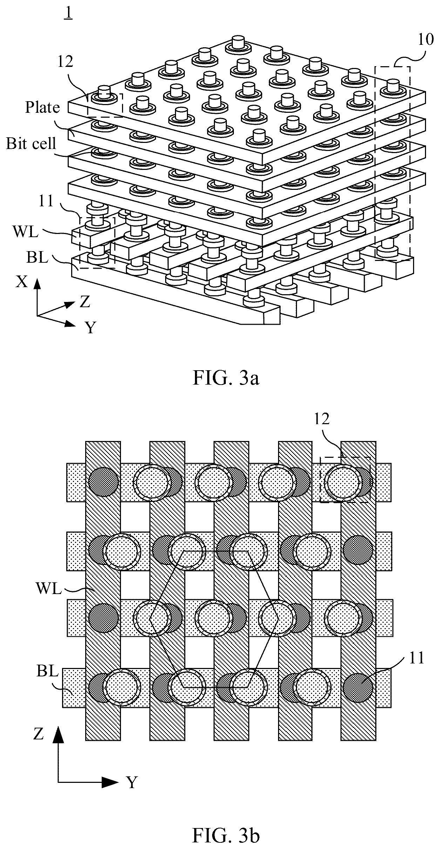

FIG. 3a is a diagram of a structure of a memory array 1 based on a 1TnC structure. As shown in FIG. 3a, each memory array 1 may include a plurality of memory cells 10. A memory cell 10 includes a transistor 11 and at least one capacitor 12 that are stacked in a first direction X, and the at least one capacitor 12 is electrically connected to a side that is of the transistor 11 and that is away from the substrate 2.

The capacitor 12 may be a ferroelectric capacitor. In this way, the memory 01 is a ferroelectric memory, and the ferroelectric memory is characterized by non-volatile storage of data and a high access rate. For example, a capacitor layer in the capacitor 12 may be made of a ferroelectric material like ZrO₂, HfO₂, Al-doped HfO₂, Si-doped HfO₂, Zr-doped HfO₂, La-doped HfO₂, or Y-doped HfO₂, or a material based on such material doped with another element, and any combination thereof.

When there is one capacitor 12, the memory cell 10 has a 1T1C (1-transistor-1-capacitor) structure, that is, one memory cell 10 includes one capacitor 12 and one transistor 11. When there are n capacitors 12, the memory cell 10 has a 1TnC (1-transistor-n-capacitor) structure, that is, one memory cell 10 includes n capacitors 12 and one transistor 11.

One memory cell 10 includes one transistor 11 and n capacitors 12, the n capacitors 12 may be used to form n bit cells (bit cell) that are stacked, and the n bit cells share the transistor 11. The following merely uses the memory cell 10 of the 1TnC structure as an example for description.

Still refer to FIG. 3a. The memory array 1 may further include a plurality of bit lines (bit line, BL), a plurality of word lines (word line, WL), and a plurality of memory cell physical layers (plate). Each of the plurality of memory cell physical layers includes a plurality of bit cells (that is, bit cell) disposed on one layer of plane. In some embodiments, the plurality of bit cells are arranged in a plurality of rows and a plurality of columns. For each memory cell physical layer, a plurality of bit cells (that is, a plurality of bit cells arranged in a third direction Z) located in a same row share a same word line WL, and a plurality of bit cells (that is, a plurality of bit cells arranged in a second direction Y) located in a same column share a same bit line BL. Memory cells 10 in a same row at a same location in different memory cell physical layers also share a same word line WL, and memory cells 10 in a same column at a same location in different memory cell physical layers also share a same bit line BL.

In some other embodiments, as shown in FIG. 3b, a plurality of bit cells may alternatively be arranged in a honeycomb structure. For example, a plurality of bit cells (that is, a plurality of bit cells arranged in a second direction Y) in a same column share a same bit line BL, and a plurality of bit cells that share a same word line WL are staggered in a third direction Y. Seven bit cells may constitute a honeycomb structure, and the seven bit cells may be respectively located at six vertexes of a hexagon and at a central point of the hexagon. The seven bit cells that constitute the honeycomb structure correspond to three word lines WL.

Further, the three-dimensional memory 01 may further include a sense amplifier (sense amplifier, SA), and the sense amplifier SA may be configured to amplify a signal in a read/write process of the three-dimensional memory 01. Optionally, the sense amplifier SA may include a bit line sense amplifier BL_SA and/or a global sense amplifier (global sense amplifier, GSA). In addition, the three-dimensional memory 01 may further include one or more of other devices such as a row (row) address decoder (decoder), a column (column) address decoder, a physical layer address decoder, and a bit line selector (BL MUX).

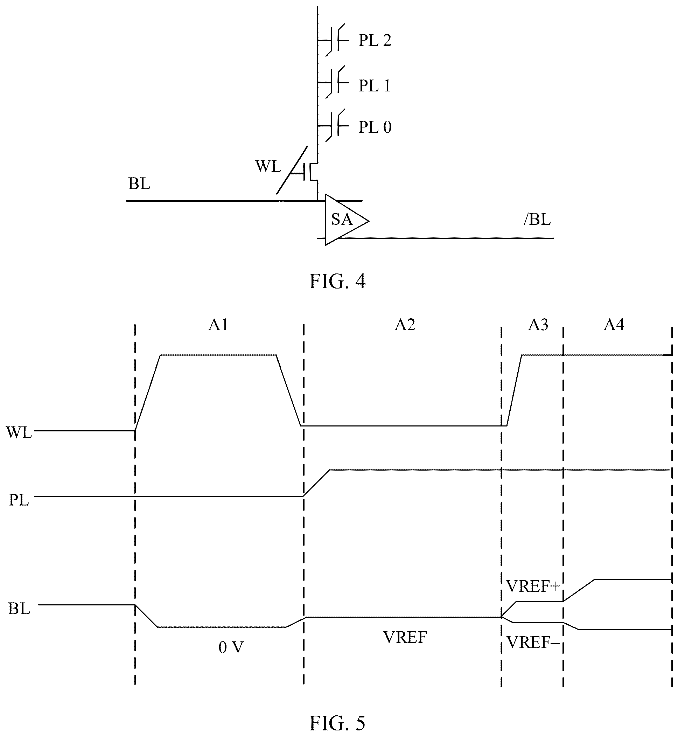

The following uses a 1TnC (for example, n=3) structure in the three-dimensional ferroelectric memory 01 as an example to describe a procedure of reading a bit cell. FIG. 4 is a diagram of a circuit structure of a memory cell 10 in a memory array 1 based on a 1TnC structure. FIG. 5 is a read timing diagram of a memory cell 10 in a memory array 1 based on a 1TnC structure. For example, as shown in FIG. 4, the 1TnC structure includes a transistor and three capacitors. A gate of the transistor is connected to a word line WL, an electrode (for example, a source electrode or a drain electrode) of the transistor is coupled to a bit line BL and a bit line sense amplifier BL_SA, and the bit line sense amplifier BL_SA is further coupled to an inverted phase /BL of the bit line BL. Another electrode (for example, the source electrode or the drain electrode) of the transistor is connected to a first end of each of the three capacitors, and second ends of the three capacitors are respectively connected to plate lines (that is, a PL 0, a PL 1, and a PL 2) of three memory cell physical layers in a one-to-one correspondence.

In an embodiment, a read procedure of the memory cell 10 may include four stages: a pre-charge (pre-charge) stage A1, a switch (switch) stage A2, a charge sharing (charge sharing) stage A3, and a sense amplification stage A4, respectively. A timing diagram of the four stages may be shown in FIG. 5.

In the pre-charge stage A1, the word line WL is set to a high level, and potential of a first end of a capacitor in the memory cell 10 is pulled down to 0 V by potential of the bit line BL. Then, the word line WL is set to a low level, and a second end of the capacitor is in a floating (floating) state.

In the switch stage A2, the first end of the capacitor remains in the floating state, potential of a layer line PL is changed from a low level to a high level, and charge stored in the memory cell 10 is read. In a process in which the potential of the layer line PL is changed from low to high, the potential of the first end of the capacitor is raised due to a coupling (coupling) effect. In this case, the potential of the bit line BL and potential of the inverted phase /BL of the bit line 14 both remain at a reference voltage VREF.

In the charge sharing stage A3, the word line WL is turned on, and the first end of the capacitor shares charge with the bit line BL. If data stored in the memory cell 10 is 0, no charge is released from the memory cell 10. Due to the coupling effect, the potential of the first end of the capacitor is slightly raised (lower than VREF). The potential of the bit line BL is pulled down by the potential of the first end of the capacitor to obtain VREF-, where VREF- is lower than the potential VREF of the inverted phase /BL of the bit line 14. If data stored in the memory cell 10 is 1, charge is released from the memory cell 10, and the coupling effect raise the potential of the first end of the capacitor (higher than VREF), and the potential of the bit line BL is pulled up by the potential of the first end of the capacitor to obtain VREF+, which is higher than the potential VREF of the inverted phase /BL of the bit line 14.

In the sensing amplification stage A4, the SA corresponding to the bit line BL amplifies a potential difference between the bit line BL and the inverted phase /BL of the bit line 14, so as to determine that read data is "0" or "1".

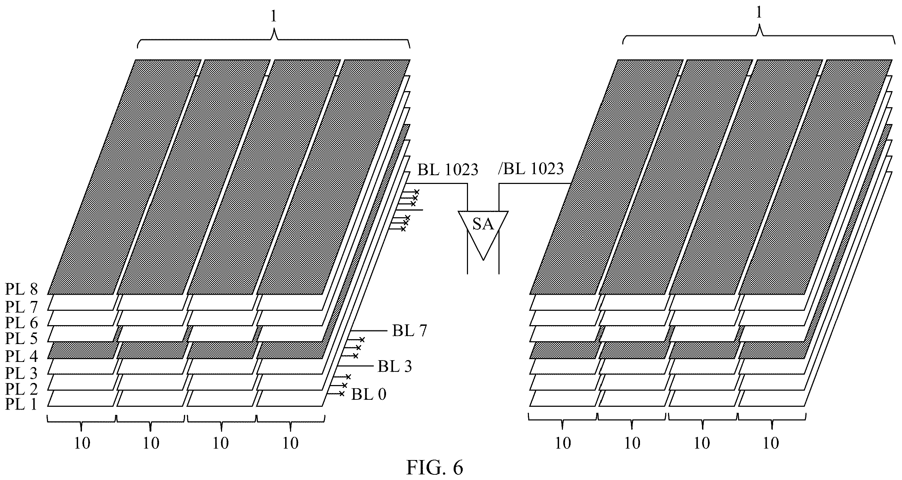

FIG. 6 is a diagram of an example of a structure of a connection of a plurality of memory arrays 1 in a memory 01 according to some embodiments. As shown in FIG. 6, in this embodiment of this application, to reduce power consumption of pulling up or pulling down potential of a layer line PL, the plurality of memory arrays 1 constitute a memory array 1 tile (MAT), and the plurality of memory arrays 1 in the memory array 1 tile share a plurality of bit lines BLs.

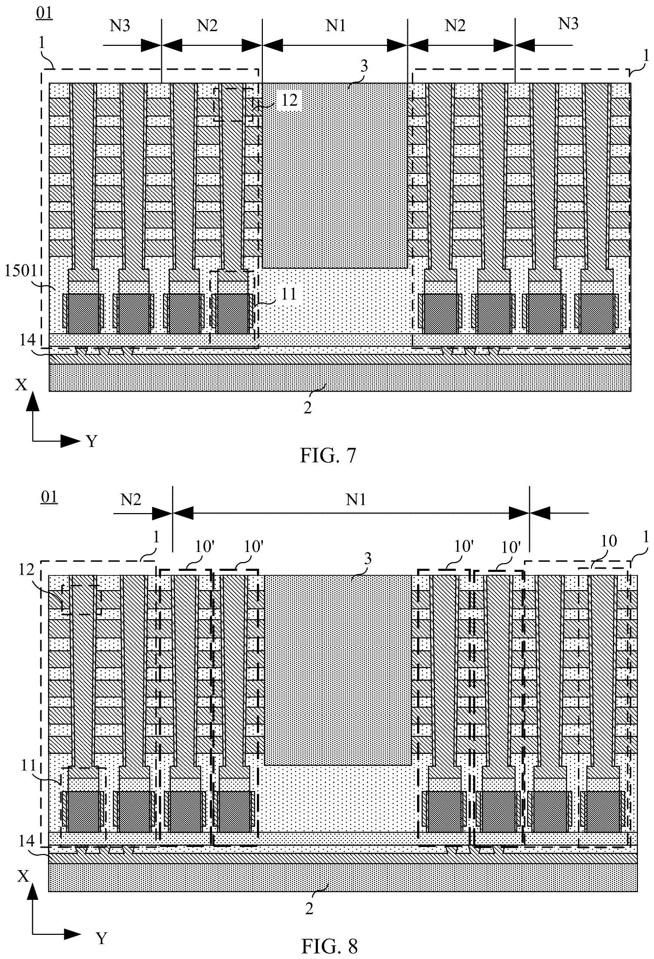

FIG. 7 is a diagram of an example of a structure of a memory 01 according to some embodiments. As shown in FIG. 7, the memory 01 further includes an isolation spacer 3. The isolation spacer 3 is located on a substrate 2. In a direction parallel to the substrate 2, the isolation spacer 3 is located between two adjacent memory arrays 1. The isolation spacer 3 is disposed to implement at least partial electrical isolation between the two adjacent memory arrays 1. For example, the isolation spacer 3 may be located between capacitors 12 of the two adjacent memory arrays 1, and there is a specific distance between the isolation spacer 3 and the substrate 2. The isolation spacer 3 may be a spacer (spacer) formed by filling an isolation material in a slit (slit).

The memory 01 further includes an insulating portion 1501, where the insulating portion 1501 is located between the isolation spacer 3 and the substrate 2. For example, in the direction parallel to the substrate 2, the insulating portion 1501 is further located between transistors 11 of memory arrays 1, and is located between transistors 11 of the two adjacent memory arrays 1. The insulating portion 1501 is disposed to implement isolation between the transistors 11 of the memory arrays 1, and to implement isolation between the transistors 11 of the two adjacent memory arrays 1.

Because a plurality of memory arrays 1 are spaced from each other, structure density of an isolation region N1 is lower than that of an edge region N2 of the memory array 1. Because the edge region N2 is adjacent to and between the isolation region N1 and a central region N3, in a direction from the central region N3 of the memory array 1 to the isolation region N1, structure density is reduced. Herein, the "isolation region N1" refers to a region located between adjacent memory arrays 1, the "edge region N2" refers to a region located at an edge of the memory array 1, and the "center region N3" refers to a region located at a center of the memory array 1. Division of the "isolation region", the "edge region", and the "center region" is merely an example, and specific sizes of the regions are not limited in this embodiment of this application. Herein, the "structure density" refers to a quantity of transistors in a unit area of such region.

During preparation of the memory array 1, you need to use processes such as etching (Etch) and chemical mechanical polishing (Chemical Mechanical Polishing, CMP) to prepare the transistor 11. It may be understood that structures of the transistors 11 of the plurality of memory arrays 1 need to be synchronously prepared by using these processes. Because there is a great difference between the structure density of the isolation region N1 and the structure density of the edge region N2, during the foregoing preparation process, a process defect may occur in a film layer structure located in the edge region N2, resulting in functional degradation of a transistor 11 located in the edge region N2 (for example, an off-state current is excessively high). Functional degradation of the transistor reduces read/write throughput of the memory.

In some embodiments, to resolve a problem of a connectivity failure of the transistor 11 located in the edge region of the memory array 1, a virtual memory cell 10' is usually added to the isolation region N1. FIG. 8 is a diagram of an example of a structure of another memory 01 according to some embodiments. As shown in FIG. 8, in each memory array 1, a plurality of virtual memory cells 10' may be added on a side of the memory array 1. A structure of the virtual memory cell 10' may be the same as that of memory cells 10. The virtual memory cell 10' may not play a storage role, but may play a role of providing mechanical support and/or load balancing for the three-dimensional memory 01. The virtual memory cell 10' is disposed to help mitigate a problem that there is a great difference between structure density of an isolation region N1 and structure density of an edge region N2. Therefore, during processes such as etching and chemical mechanical polishing, a film layer structure of the memory cells 10 adjacent to the virtual memory cells 10' is not easily deformed, thereby mitigating a performance degradation phenomenon of the transistor 11 in the edge region N2 of the memory array 1.

However, the virtual memory cell 10' is disposed to increase an occupied area of the memory 01, thereby reducing storage density of the memory 01. For example, when each memory array 1 includes 64 memory cells 10 distributed in the array, two columns of virtual memory cells 10' are added to a side of each memory array 1, so that an occupied area of the memory array 1 is increased by about 5%.

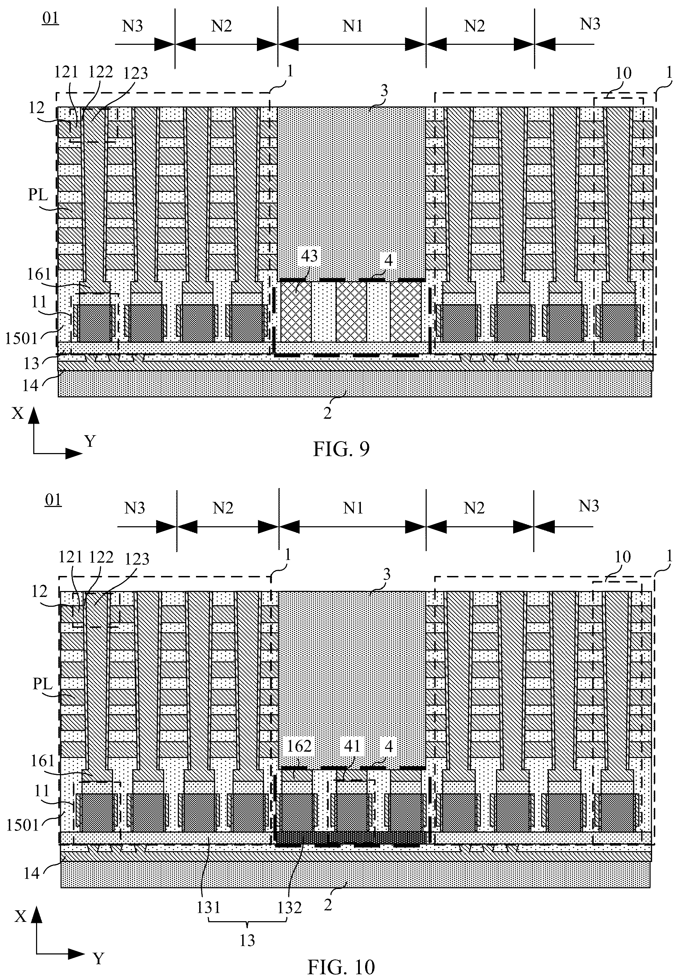

FIG. 9 is a diagram of an example of a structure of another memory according to an embodiment of this application. FIG. 10 is a diagram of an example of a structure of another memory 01 according to an embodiment of this application. As shown in FIG. 9 and FIG. 10, the memory 01 provided in this embodiment of this application further includes a filling structure 4. The filling structure 4 is located on a substrate 2 and is located between transistors 11 of two adjacent memory arrays 1. For example, the filling structure 4 is further located between the substrate 2 and an isolation spacer 3, that is, the isolation spacer 3 is located on a side that is of the filling structure 4 and that is away from the substrate 2.

Based on this structure, an insulating portion 1501 is further located between the filling structure 4 and the memory array 1, the insulating portion 1501 is further located between the isolation spacer 3 and the memory array 1, and the insulating portion 1501 and the filling structure 4 are made of different materials. Herein, the "different materials" means that at least a part of film layers of the insulating portion 1501 and the filling structure 4 are made of different materials. For example, all the film layers of the insulating portion 1501 and the filling structure 4 are made of different materials, or a part of the film layers of the insulating portion 1501 and the filling structure 4 are made of different materials. In this way, the insulating portion 1501 can implement isolation effect between the isolation spacer 3 and the memory array 1, and can further implement isolation effect between the filling structure 4 and the memory array 1.

The filling structure 4 may be formed before the transistor 11, or the filling structure 4 and the transistor 11 may be prepared synchronously. The filling structure 4 is disposed between the two adjacent memory arrays 1, to increase structure density of an isolation region N1, thereby reducing a difference between structure density of an edge region N2 of the memory array 1 and the structure density of the isolation region N1. In this way, during the preparation process, a process defect of a film layer structure in the edge region N2 of the memory array 1 can be mitigated, thereby mitigating a performance degradation phenomenon of the transistor 11 in the edge region of the memory array 1.

As shown in FIG. 9, in some embodiments, the filling structure 4 may include, for example, a support block 43, and a material of the support block 43 may include an insulating material. The material of the support block 43 may include, for example, one of silicon dioxide and silicon nitride. A quantity of support blocks 43 is not specifically limited in this embodiment of this application, provided that the difference between the structure density of the edge region N2 of the memory array 1 and the structure density of the isolation region N1 can be reduced. For example, the filling structure 4 may include three support blocks 43 that are spaced from each other. In this way, the film layer structure of the support block 43 is simple, which helps improve normalization of the filling structure 4, and further improves a function of the filling structure 4 to provide mechanical support and/or load balancing. In addition, the material of the support block 43 is set to the insulating material, which further helps avoid interference caused by the support block 43 to another transistor 11, and helps improve the performance of the memory array 1.

Certainly, in some other embodiments, the filling structure 4 may further include a plurality of film layer structures. For example, as shown in FIG. 10, the filling structure 4 may include a virtual transistor 41, at least a part of film layers of the virtual transistor 41 and at least a part of film layers of the transistor 11 are disposed at a same layer, and the virtual transistor 41 and the transistor 11 are spaced from each other. Herein, the term "spaced from each other" means that there is a specific distance between the virtual transistor 41 and the transistor 11, so that the virtual transistor 41 does not contact the transistor 11. This helps simplify the preparation process of the filling structure 4, improves the preparation efficiency of the memory 01, and reduces the preparation costs of the memory 01.

In some embodiments, all the film layers of the virtual transistor 41 and structures of all the film layers of the transistor 11 may be disposed at a same layer, so that the virtual transistor 41 and the transistor 11 have a same structure. In some other embodiments, a part of the film layers of the virtual transistor 41 and a part of the film layers of the transistor 11 may be disposed at a same layer. Herein, the virtual transistor 41 may not perform a control function, but performs a function of providing mechanical support and/or load balancing for the three-dimensional memory 01.

A quantity of virtual transistors 41 is not limited in this embodiment of this application. There may be one or more virtual transistors 41. When there is one virtual transistor 41, the virtual transistor 41 may be located between any group of adjacent memory arrays 1. When there are a plurality of virtual transistors 41, each of the plurality of virtual transistors 41 may be located between a group of adjacent memory arrays 1, or one or more virtual transistors 41 may be disposed between a plurality of groups of adjacent memory arrays 1.

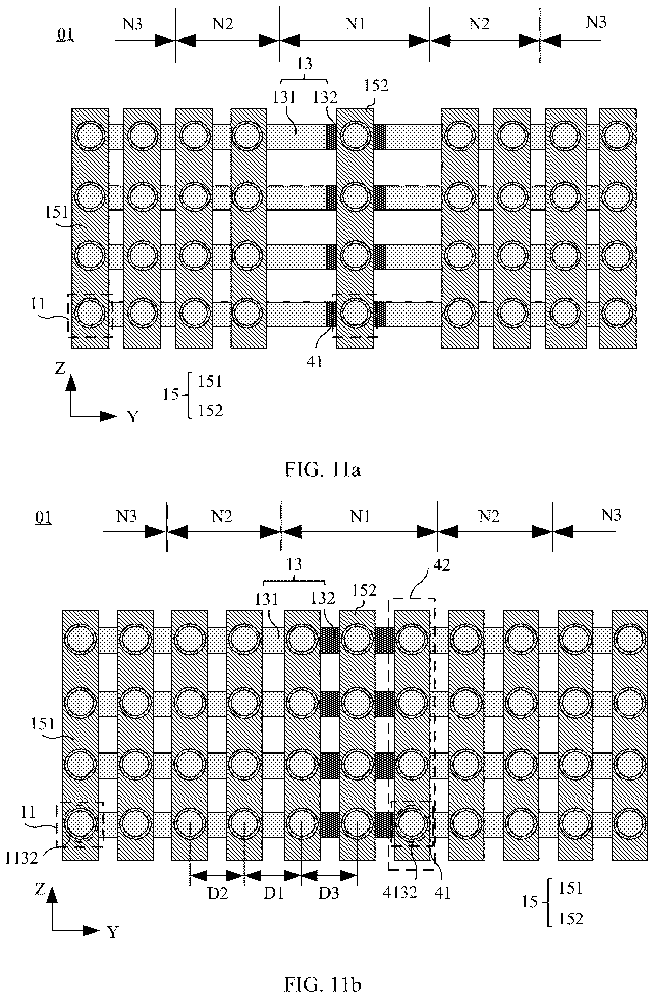

FIG. 11a is a top view of an example of a memory 01 in which a capacitor 12 and an isolation spacer 3 are omitted according to an embodiment of this application. FIG. 11b is a top view of an example of another memory 01 in which a capacitor 12 and an isolation spacer 3 are omitted according to an embodiment of this application. With reference to FIG. 10, FIG. 11a, and FIG. 11b, in each memory array 1, a plurality of memory cells 10 may be spaced from each other in a second direction Y, and the plurality of memory cells 10 may be spaced from each other in a third direction Z. Because each memory cell 10 includes one transistor 11 and at least one capacitor 12 that are stacked in a first direction X, a plurality of transistors 11 may be spaced from each other in the second direction Y, and the plurality of transistors 11 may be spaced from each other in the third direction Z.

Refer to FIG. 11a. There are a plurality of virtual transistors 41 between two adjacent memory arrays 1, the plurality of virtual transistors 41 are spaced from each other in the third direction Z, and the virtual transistors 41 and the plurality of transistors 11 arranged in the second direction Y are spaced from each other in the second direction Y. For example, each memory array 1 may include 16 transistors 11 arranged in an array. For example, the plurality of transistors 11 are arranged in four rows, and each row includes four transistors 11. Correspondingly, the plurality of virtual transistors 41 may be arranged in columns, and each virtual transistor 41 and a corresponding row of transistors 11 are spaced from each other in the third direction Z.

This can further increase structure density of an isolation region N1, further reduce a difference between structure density of an edge region N2 of the memory array 1 and the structure density of the isolation region N1. In this way, a process defect of a film layer structure in each row of the edge region of the memory array 1 is mitigated, thereby further mitigating a performance degradation phenomenon of the transistor 11 in the edge region N2 of the memory array 1.

Further, refer to FIG. 11b, a plurality of virtual transistors 41 arranged in the third direction Z may constitute a virtual transistor group 42, there are a plurality of virtual transistor groups 42 between the two adjacent memory arrays 1, and the plurality of virtual transistor groups 42 are spaced from each other in the second direction Y. For example, three virtual transistor groups 42 may be disposed between two adjacent memory arrays 1, and the three virtual transistor groups 42 are spaced from each other in the second direction Y. A quantity of virtual transistor groups 42 is increased, to further increase structure density of an isolation region N1, further reduce a difference between structure density of an edge region N2 of the memory array 1 and the structure density of the isolation region N1. In this way, a process defect of a film layer structure in each row of the edge region of the memory array 1 is mitigated, thereby further mitigating a performance degradation phenomenon of the transistor 11 in the edge region N2 of the memory array 1.

Based on the foregoing structure, structure density of the isolation region N1 may be further adjusted by adjusting a location of the virtual transistor 41. In some embodiments, a distance D1 between the virtual transistor 41 and the transistor 11 that are arranged in the second direction Y and that are adjacent to each other is equal to a distance D2 between two transistors 11 that are arranged in the second direction Y and that are adjacent to each other. It may be understood that, the transistor 11 that is in the memory array 1 and that is adjacent to the virtual transistor 41 is the transistor 11 in the edge region N2 in the memory array 1. This helps further reduce the difference between the structure density of the edge region N2 of the memory array 1 and the structure density of the isolation region N1. In this way, the process defect of the film layer structure in each row of the edge region N2 of the memory array 1 is mitigated, thereby further mitigating a performance degradation phenomenon of the transistor 11 in the edge region N2 of the memory array 1.

Further, a distance D3 between two virtual transistors 41 that are arranged in the second direction Y and that are adjacent to each other can be equal to the distance D2 between the two transistors 11 that are arranged in the second direction Y and that are adjacent to each other. In other words, the plurality of virtual transistor groups 42 are equally spaced from each other in the second direction Y, a plurality of columns of transistors 11 are equally spaced from each other in the second direction Y, and a distance between the plurality of virtual transistor groups 42 is equal to a distance between the plurality of columns of transistors 11. This helps further reduce the difference between the structure density of the edge region N2 of the memory array 1 and the structure density of the isolation region N1. In this way, the process defect of the film layer structure in each row of the edge region N2 of the memory array 1 is mitigated, thereby further mitigating a performance degradation phenomenon of the transistor 11 in the edge region N2 of the memory array 1. In addition, this further helps increase arrangement normalization of the virtual transistors 41 and the transistors 11.

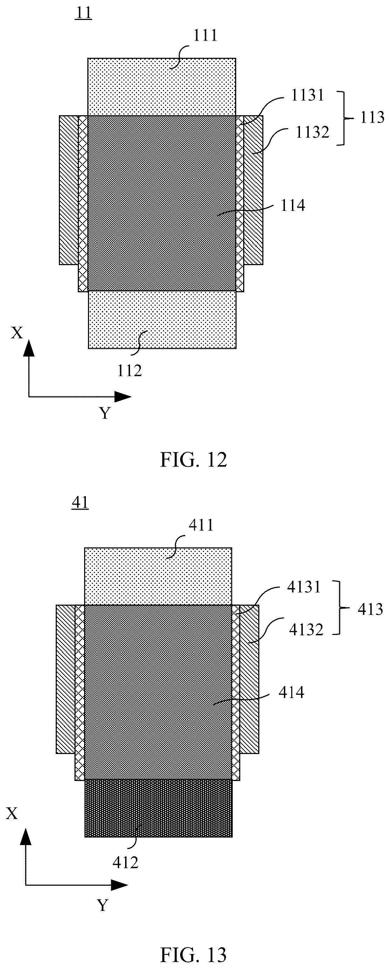

As described in the foregoing embodiment, at least a part of the film layers of the virtual transistor 41 and at least a part of the film layers of the transistor 11 may be disposed at a same layer. The following describes the structure of the virtual transistor 41 by using the transistor 11 in the memory array 1 in FIG. 10 as a reference. In some other embodiments, the structure of the transistor 11 may alternatively be another structure in the related technology, and correspondingly, the structure of the virtual transistor 41 may alternatively be another structure in the related technology. FIG. 12 is a diagram of a structure of the transistor 11 of the memory 01 in FIG. 10. FIG. 13 is a diagram of a structure of the virtual transistor 41 of the memory 01 in FIG. 10.

As shown in FIG. 12, a first electrode 111 of the transistor and a second electrode 112 of the transistor are disposed in the first direction X. With reference to FIG. 10, the first electrode 111 of the transistor is electrically connected to at least one capacitor 12, a channel layer 114 of the transistor is located between the first electrode 111 of the transistor and the second electrode 112 of the transistor, and a gate 113 of the transistor surrounds the channel layer 114 of the transistor. In an embodiment of this application, one electrode of a drain (drain) or a source (source) of the transistor 11 is referred to as the first electrode 111 of the transistor, and correspondingly, the other electrode is referred to as the second electrode 112 of the transistor, and the gate 113 of the transistor is a control end. The drain and the source of the transistor 11 may be determined based on a current flow direction.

Further, the gate 113 of the transistor surrounds the channel layer 114 of the transistor, and the gate 113 of the transistor includes a metal gate 1132 of the transistor and a gate medium layer 1131 of the transistor. The metal gate 1132 of the transistor and the channel layer 114 of the transistor are isolated by the gate medium layer 1131 of the transistor. In other words, the transistor 11 in this embodiment of this application may be a gate-all-round gate (Gate-All-Around, GAA) transistor.

As shown in FIG. 13, a first electrode 411 of the virtual transistor and a second electrode 412 of the virtual transistor are disposed in the first direction X. With reference to FIG. 10, the first electrode 411 of the virtual transistor is connected to the isolation spacer 3, a channel layer 414 of the virtual transistor is located between the first electrode 411 of the virtual transistor and the second electrode 412 of the virtual transistor, and a gate 413 of the virtual transistor surrounds the channel layer 414 of the virtual transistor. In an embodiment of this application, one electrode of a drain (drain) or a source (source) of the virtual transistor 41 is referred to as the first electrode 411 of the virtual transistor, and correspondingly, the other electrode is referred to as the second electrode 412 of the virtual transistor, and the gate 413 of the virtual transistor is a control end. The drain and the source of the virtual transistor 41 may be determined based on a current flow direction.

Further, the gate 413 of the virtual transistor surrounds the channel layer 414 of the virtual transistor, and the gate 413 of the virtual transistor includes a metal gate 4132 of the virtual transistor and a gate medium layer 4131 of the virtual transistor. The metal gate 4132 of the virtual transistor and the channel layer 414 of the virtual transistor are isolated by the gate medium layer 4131 of the virtual transistor. In other words, the virtual transistor 41 in this embodiment of this application may further be a gate-all-round gate transistor.

In an embodiment of this application, for example, the transistor 11 and the virtual transistor 41 shown in FIG. 10 may be a selected NMOS (N-channel metal oxide semiconductor, N-channel metal oxide semiconductor) transistor, or may be a selected PMOS (P-channel metal oxide semiconductor, P-channel metal oxide semiconductor) transistor.

Based on this structure, the first electrode 111 of the transistor and the first electrode 411 of the virtual transistor may be disposed at a same layer, the channel layer 114 of the transistor and the channel layer 414 of the virtual transistor may be disposed at a same layer, and the gate 113 of the transistor and the gate 413 of the virtual transistor may be disposed at a same layer. This helps simplify preparation processes of the transistor 11 and the virtual transistor 41, improves the preparation efficiency of the memory 01, and reduces the preparation costs of the memory 01.

For example, materials of both the first electrode 111 of the transistor and the first electrode 411 of the virtual transistor are conductive materials, and may include, for example, one of conductive materials such as TiN (titanium nitride), Ti (titanium), Au (gold), W (tungsten), Mo (molybdenum), In-Ti-O (ITO, indium tin oxide), Al (aluminum), Cu (copper), Ru (ruthenium), and Ag (silver), or a combination thereof.

For example, materials of both the metal gate 1132 of the transistor and the metal gate 4132 of the virtual transistor may be metal materials, and may include, for example, one of conductive materials such as Ti (titanium), Au (gold), W (tungsten), Mo (molybdenum), Al (aluminum), Cu (copper), Ru (ruthenium), and Ag (silver), or a combination thereof.

For example, materials of the channel layer 114 of the transistor and the channel layer 414 of the virtual transistor may include one of semiconductor materials such as Si (silicon), poly-Si (p-Si, polycrystalline silicon), amorphous-Si (a-Si, amorphous silicon), In-Ga-Zn-O (IGZO, indium gallium zinc oxide) multi-component compound, ZnO (zinc oxide), ITO (indium tin oxide), TiO₂ (titanium dioxide), MoS₂ (molybdenum dioxide), WS₂ (tungsten dioxide), graphene, and black phosphorus, or a combination thereof.

For example, materials of the gate medium layer 1131 of the transistor and the gate medium layer 4131 of the virtual transistor may include one of insulating materials such as SiO₂ (silicon dioxide), Al₂O₃ (aluminum oxide), HfO₂ (propylene dioxide), ZrO₂ (zirconia), TiO₂ (titanium dioxide), Y₂O; (diyttrium trioxide), and Si₃N₄ (silicon nitride), or a combination thereof.

Based on this structure, in some embodiments, the second electrode 112 of the transistor and the second electrode 412 of the virtual transistor may be disposed at a same layer, and all film layer structures of the virtual transistor 41 and the transistor 11 may be disposed at a same layer, so that the virtual transistor 41 and the transistor 11 have a same structure.

However, in some other embodiments, the second electrode 112 of the transistor and the second electrode 412 of the virtual transistor may be made of different materials. For example, the second electrode 112 of the transistor and the first electrode 111 of the transistor may be made of a same material, that is, the first electrode 111 of the transistor is made of a conductive material. A material of the second electrode 412 of the virtual transistor may be an insulating material, so that the virtual transistor 41 does not have a control function.

With reference to FIG. 10 and FIG. 11a, the memory 01 further includes a plurality of conducting wires 13 that are spaced from each other in the third direction Z, an extension direction of the conducting wire 13 is parallel to the second direction Y, the conducting wire 13 may include a plurality of conducting portions 131 and a plurality of dielectric portions 132, and the conducting portion 131 and the dielectric portion 132 are alternately disposed in the second direction Y. For example, the conducting portion 131 of the conducting wire 13 is directly opposite to the transistor 11 of the memory array 1, and the dielectric portion 132 of the conducting wire 13 is directly opposite to the virtual transistor 41. Based on this structure, the conducting portion 131 and the second electrode 112 of the transistor may be disposed at a same layer and in contact with each other, and the dielectric portion 132 and the second electrode 412 of the virtual transistor may be disposed at a same layer and in contact. This helps simplify preparation processes of the transistor 11 and the virtual transistor 41, and can improve the preparation efficiency of the memory 01 and reduce the preparation costs of the memory 01.

In addition, the dielectric portion 132 of the conducting wire 13 and the second electrode 412 of the virtual transistor are disposed at a same layer and in contact, so that the virtual transistor 41 does not have a control function. This helps prevent the virtual transistor 41 from interfering with another transistor 11, and helps improve performance of the memory array 1.

In some embodiments, second electrodes 112 of a plurality of transistors arranged in the second direction Y may be connected to form an integrated structure, to form the conducting portion 131. In an embodiment in which there are a plurality of virtual transistors 41, second electrodes 412 of a plurality of virtual transistors arranged in the second direction Y may be connected to form an integrated structure, to form the dielectric portion 132, and the dielectric portion 132 is adjacent to the conducting portion 131. Because the virtual transistor 41 is located between two adjacent memory arrays 1, the dielectric portion 132 and the conducting portion 131 are alternately disposed.

Further, the memory 01 further includes a plurality of bit lines 14 that are spaced from each other in the third direction Z, the bit line 14 is located between the conducting wire 13 and the substrate 2, an extension direction of the bit line 14 is parallel to the second direction Y, and the bit line 14 is electrically connected to the conducting portion 131 of the conducting wire 13. For example, the bit line 14 may be located on a side that is of the conducting wire 13 and that is away from the transistor 11, and one bit line 14 directly opposite to one conducting wire 13. A plurality of contact pillars are further disposed on each bit line 14, and one end that is of the contact pillar and that is away from the bit line 14 is connected to the conducting portion 131 of the conducting wire 13, so that the bit line 14 is electrically connected to the conducting portion 131.

Still refer to FIG. 10 and FIG. 11a. The memory 01 may further include a plurality of word lines 15 that are spaced from each other in the second direction Y, and an extension direction of the word line 15 is parallel to the third direction Z. At least one word line 15 is electrically connected to gates 113 of a row of transistors arranged in the third direction Z, and at least one word line 15 is electrically connected to gates 413 of a row of virtual transistors arranged in the third direction Z.

For ease of distinguishing, the word line 15 is divided into a first word line 151 and a second word line 152. The first word line 151 is electrically connected to gates 113 of a row of transistors arranged in the third direction Z, and the second word line 152 is electrically connected to gates 413 of a row of virtual transistors arranged in the third direction Z.

For example, the first word line 151 surrounds the gate 113 of the transistor, the first word line 151 and the gate 113 of the transistor may be disposed at a same layer, the second word line 152 surrounds the gate 413 of the virtual transistor, and the second word line 152 and the gate 413 of the virtual transistor may be disposed at a same layer. The second word line 152 and the first word line 151 are disposed at a same layer. This helps simplify the preparation processes of the transistor 11 and the virtual transistor 41, improves the preparation efficiency of the memory 01, and reduces the preparation costs of the memory 01.

In conclusion, for the transistor 11 in the memory array 1, gates 113 of the plurality of transistors arranged in the second direction Y may be electrically connected to a same word line 15, and second electrodes 112 of the plurality of transistors arranged in the third direction Z are electrically connected to a same bit line 14. The word line 15 is configured to receive a word line control signal, to turn on the transistor 11. The bit line 14 is configured to receive a bit line 14 control signal, to read or write a bit cell.

Further, as shown in FIG. 10, the memory array 1 may further include a plurality of first conductive contacts 161, one first conductive contact 161 is disposed corresponding to one transistor 11, and the first conductive contact 161 is located between the first electrode 111 of the transistor and the capacitor 12. The first conductive contact is disposed for electrical connection between the at least one capacitor 12 and the first electrode 111 of the transistor. The filling structure 4 may further include a plurality of second conductive contacts 162, one second conductive contact 162 is disposed corresponding to one virtual transistor 41, and the second conductive contact 162 is located between the first electrode 411 of the virtual transistor and the isolation spacer 3. Based on this structure, the second conductive contact 162 and the first conductive contact 161 may be disposed at a same layer. This helps simplify the preparation process of the memory 01, and can improve the preparation efficiency of the memory 01 and reduce the preparation costs of the memory 01.

The first conductive contact 161 and the second conductive contact 162 may be both made of metal materials, and may be, for example, one or more of conductive materials such as TiN (titanium nitride), Ti (titanium), Au (gold), W (tungsten), Mo (molybdenum), In-Ti-O (ITO, indium tin oxide), Al (aluminum), Cu (copper), Ru (ruthenium), and Ag (silver).

Still refer to FIG. 10. In an embodiment in which there are a plurality of capacitors 12, the plurality of capacitors 12 corresponding to one transistor 11 are stacked in the first direction X. Each capacitor 12 includes a first capacitor electrode 121, a capacitor layer 122, and a second capacitor electrode 123. For example, the first capacitor electrode 121 may surround the capacitor layer 122, and the capacitor layer 122 may surround the second capacitor electrode 123. A plurality of capacitor 12 stacked in the first direction X may share a same second capacitor electrode 123, and the second capacitor electrode 123 may also be referred to as a pillar (pillar).

In a same plane parallel to the substrate 2, the first capacitor electrode 121 of the plurality of capacitors 12 is electrically connected to a plate line (plate line, PL). The plate line PL is configured to receive a plate line control signal, where a voltage difference between the bit line control signal and the plate line control signal causes positive polarization or negative polarization of the capacitor layer 122 of a selected capacitor 12, to write different logical information into the selected capacitor 12. For example, when the capacitor layer 122 is positively polarized, a logical signal "0" is written. For another example, when the capacitor layer 122 is negatively polarized, a logical signal "1" is written.

The first capacitor electrode 121 and the second capacitor electrode 123 in the capacitor 12 are both made of conductive materials. Selectable materials may be one or more of conductive materials such as TiN (titanium nitride), Ti (titanium), Au (gold), W (tungsten), Mo (molybdenum), In-Ti-O (ITO, indium tin oxide), Al (aluminum), Cu (copper), Ru (ruthenium), and Ag (silver).

The capacitor layer 122 in the capacitor 12 may be a ferroelectric material like ZrO₂, HfO₂, Al-doped HfO₂, Si-doped HfO₂, Zr-doped HfO₂, La-doped HfO₂, or Y-doped HfO₂, or a material based on such material doped with another element, and any combination thereof.

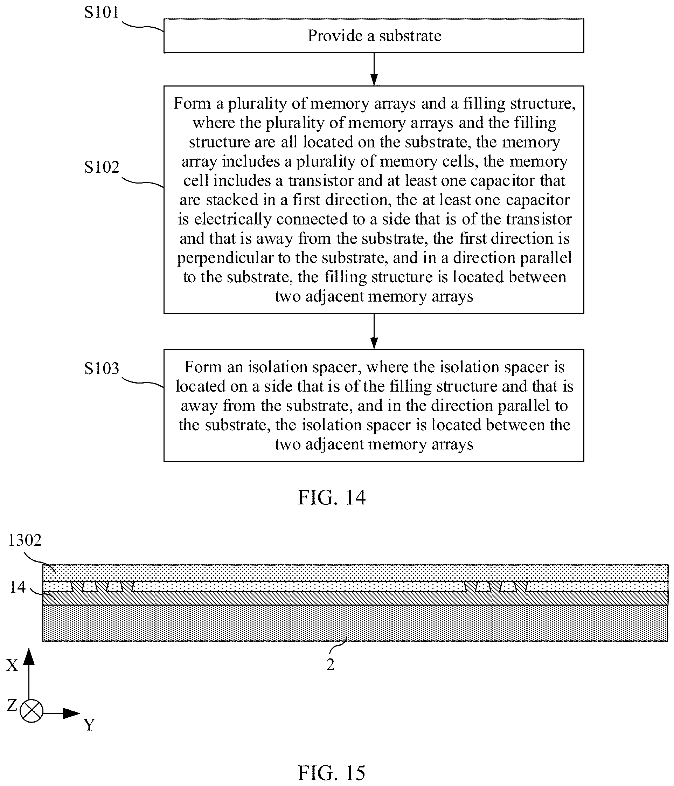

An embodiment of this application further provides a memory 01 preparation method, to prepare the memory 01 in any one of the foregoing embodiments. FIG. 14 is a flowchart of an example of steps of a memory 01 preparation method according to an embodiment of this application. With reference to FIG. 14, the preparation method includes steps S101 to S103.

S101: Provide a substrate.

The following describes a specific process procedure related to step S101 with reference to FIG. 15 to FIG. 18. In this embodiment of this application, after providing the substrate 2, the method further includes the following steps.

FIG. 15 is a diagram of an example of a structure of forming an intermediate conducting wire 1302 in a memory 01 preparation method according to an embodiment of this application. As shown in FIG. 15, a plurality of bit lines 14 that are spaced from each other in a third direction Z and a plurality of intermediate conducting wires 1302 that are spaced from each other in the third direction Z are formed, where the intermediate conducting wire 1302 is located on a side that is of the bit line 14 and that is away from a substrate 2, extension directions of the bit line 14 and the intermediate conducting wire 1302 are parallel to a second direction Y, the second direction Y and the third direction Z are both perpendicular to a first direction X, and the second direction Y intersects with the third direction Z.

In some embodiments, bit line conducting layers and intermediate conducting layers may be sequentially stacked on the substrate 2, and a party of the bit line conducting layers and intermediate conducting layers are etched, to form the plurality of bit lines 14 that are spaced from each other in the third direction Z and the plurality of intermediate conducting wires 1302 that are spaced from each other in the third direction Z. A material of the bit line 14 may be described in the foregoing embodiments. Details are not described in this embodiment of this application.

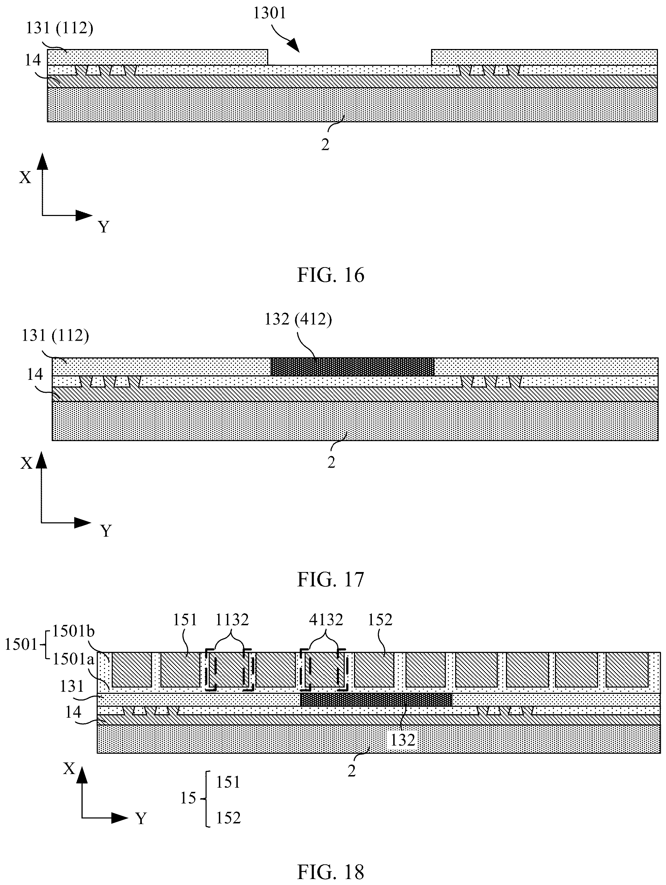

FIG. 16 is a diagram of an example of a structure of removing a part of intermediate conducting wires 1302 in a memory 01 preparation method according to an embodiment of this application. Refer to FIG. 16. After forming intermediate conducting wires 1302, the method further includes: removing the part of the intermediate conducting wires 1302, to form a plurality of grooves 1301 that are spaced from each other, where an intermediate conducting wire 1302 between adjacent grooves 1301 constitutes a conducting portion 131. For example, the part of intermediate conducting wires 1302 may be removed by using a process like exposure or etching, to form the plurality of grooves 1301. The remaining intermediate conducting wire 1302 between adjacent grooves 1301 is the conducting portion 131.

Further, when a plurality of conducting portions 131 are formed, a second electrode 112 of a transistor is further formed. In other words, the conducting portion 131 and the second electrode 112 of the transistor are disposed at a same layer. The conducting portion 131 and the second electrode 112 of the transistor are made of a same material. The material may be described in the foregoing embodiments, and details are not described herein again.

FIG. 17 is a diagram of an example of a structure of forming a dielectric portion 132 in a memory 01 preparation method according to an embodiment of this application. Refer to FIG. 17. The dielectric portion 132 is formed in a groove 1301, and a conducting portion 131 and the dielectric portion 132 that are alternately disposed in a second direction Y constitute a conducting wire 13. For example, the groove 1301 may be filled with a dielectric material by using a process like deposition. After the dielectric material is filled, a surface of the dielectric material may be flattened by using a chemical mechanical grinding process, to form the dielectric portion 132, and a surface that is of the dielectric portion 132 and that is away from a substrate 2 and a surface that is of the conducting portion 131 and that is away from the substrate 2 are located in a same plane.

In some embodiments, a filling structure 4 includes a virtual transistor 41. Further, when the dielectric portion 132 is formed in the groove 1301, a second electrode 412 of the virtual transistor is further formed. In other words, the dielectric portion 132 and the second electrode 412 of the virtual transistor are disposed at a same layer. The dielectric portion 132 and the second electrode 412 of the virtual transistor are made of a same material. The material may be described in the foregoing embodiments, and details are not described herein again.

In this embodiment of this application, after the second electrode 412 of the virtual transistor is formed, the method further includes: forming an insulating portion 1501.

FIG. 18 is a diagram of an example of a structure of forming an insulating portion 1501 in a memory 01 preparation method according to an embodiment of this application. Refer to FIG. 18. An insulation layer 1501a may be formed on a conducting portion 131 and a dielectric portion 132. After the insulation layer 1501a is formed, a plurality of word lines 15 that are spaced from each other in a second direction Y are formed on the insulation layer 1501a. The word line 15 is located on a side that is of a conducting wire 13 and that is away from a substrate 2, and an extension direction of the word line 15 is parallel to a third direction Z. For example, the word line 15 includes a first word line 151 and a second word line 152, where a projection of the first word line 151 on the conducting wire 13 intersects with the conducting portion 131, and a projection of the second word line 152 on the conducting wire 13 intersects with the dielectric portion 132.

In some embodiments, after the insulation layer 1501a is formed, a word line conducting layer may be formed on the insulation layer 1501a, to implement electrical isolation between the subsequently formed word line 15 and the conducting wire 13, and a part of the word line conducting layers is removed to form the first word line 151 and the second word line 152. In this way, the first word line 151 and the second word line 152 are disposed at a same layer.

Further, after the first word line 151 and the second word line 152 are formed, an insulating material 1501b may be further filled between the two adjacent word lines 15. The insulating material 1501b and the insulation layer 1501a are made of the same material, so that the insulating material 1501b and the insulation layer 1501a jointly constitute the insulating portion 1501, to implement electrical isolation between the two adjacent word lines 15. In this way, the insulating portion 1501 is located between a plurality of transistors 11 of the memory array 1, and in a direction parallel to the substrate 2, the insulating portion 1501 is further located between adjacent transistors 11 of the memory array 1.

In an embodiment in which a filling structure 4 includes a virtual transistor 41, when the plurality of word lines 15 that are spaced from each other in the second direction Y are formed, a metal gate 1132 of the transistor and a metal gate 4132 of the virtual transistor are further formed. In other words, the first word line 151 and the metal gate 1132 of the transistor are disposed at a same layer and in contact, and the second word line 152 and the metal gate 4132 of the virtual transistor are disposed at a same layer and in contact. Materials thereof may be as described in the foregoing embodiments, and details are not described herein again.

In this embodiment of this application, after the conducting wire 13 is formed, the method further includes the following step.

S102: Form a plurality of memory arrays and a filling structure, where the plurality of memory arrays and the filling structure are all located on the substrate, the memory array includes a plurality of memory cells, the memory cell includes a transistor and at least one capacitor that are stacked in a first direction, the at least one capacitor is electrically connected to a side that is of the transistor and that is away from the substrate, the first direction is perpendicular to the substrate, and in a direction parallel to the substrate, the filling structure is located between two adjacent memory arrays.

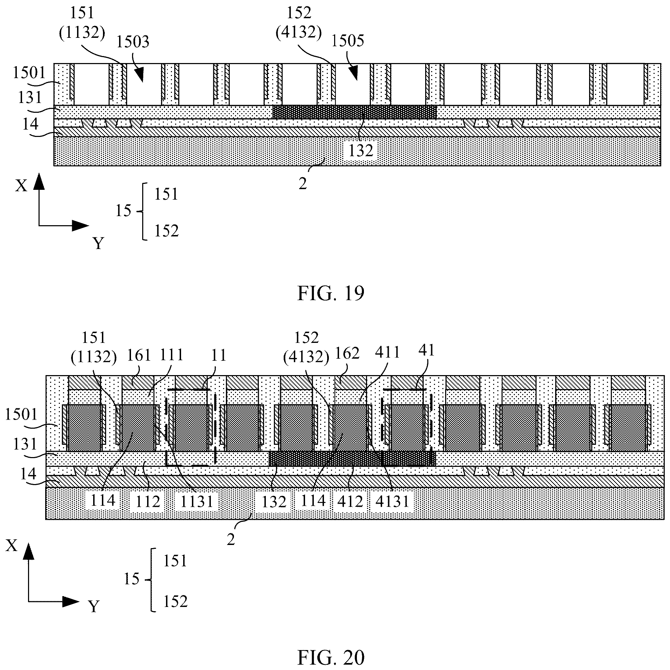

The following describes a specific process procedure related to step S102 with reference to FIG. 19 to FIG. 23. In this embodiment of this application, the step of forming the plurality of memory arrays 1 and the filling structure 4 further includes the following steps.

FIG. 19 is a diagram of an example of a structure of forming a first channel hole 1503 and a second channel hole 1505 in a memory 01 preparation method according to an embodiment of this application. As shown in FIG. 19, the first channel hole 1503 and the second channel hole 1505 that pass through a word line 15 is formed. The first channel hole 1503 may pass through a first word line 151 to a conducting portion 131 of a conducting wire 13. The second channel hole 1505 may pass through a second word line 152 to a dielectric portion 132 of the conducting wire 13.

FIG. 20 is a diagram of an example of a structure of forming a transistor 11 and a virtual transistor 41 in a memory 01 preparation method according to an embodiment of this application. As shown in FIG. 20, a first channel hole 1503 and a second channel hole 1505 are filled with a gate medium material and a channel material, to form a gate medium layer 1131 of the transistor and a channel layer 114 of the transistor in the first channel hole 1503, and form a gate medium layer 4131 of the virtual transistor and a channel layer 414 of the virtual transistor in the second channel hole 1505. A metal gate 1132 of the transistor and the gate medium layer 1131 of the transistor constitute a gate 113 of the transistor. The gate 113 of the transistor surrounds the channel layer 114 of the transistor. A metal gate 4132 of the virtual transistor and the gate medium layer 4131 of the virtual transistor constitute a gate 413 of the virtual transistor. The gate 413 of the virtual transistor surrounds the channel layer 414 of the virtual transistor.

In this way, the gate 113 of the transistor and the gate 413 of the virtual transistor are disposed at a same layer. Materials thereof may be the same as that described in the foregoing embodiments, and details are not described herein again. The channel layer 114 of the transistor and the channel layer 414 of the virtual transistor are disposed at a same layer. Materials thereof may be the same as that described in the foregoing embodiments, and details are not described herein again.

As shown in FIG. 20, a first electrode 111 of the transistor and a first electrode 411 of the virtual transistor are formed, where the first electrode 111 of the transistor is located on a side that is of the channel layer 114 of the transistor and that is away from a substrate 2, and the first electrode 411 of the virtual transistor is located on a side that is of the channel layer 414 of the virtual transistor and that is away from the substrate 2. In this way, the first electrode 111 of the transistor and the first electrode 411 of the virtual transistor may be disposed at a same layer, that is, the first electrode 111 of the transistor and the first electrode 411 of the virtual transistor are made of a same material. The material may be described in the foregoing embodiments, and details are not described herein again. The formed virtual transistor 41 and the insulating portion 1501 may be made of different materials.

In this embodiment of this application, as shown in FIG. 20, after the first electrode 111 of the transistor and the first electrode 411 of the virtual transistor are formed, a first conductive contact 161 and a second conductive contact 162 are further formed. The first conductive contact 161 and the second conductive contact 162 are disposed at a same layer. The first conductive contact 161 is the same as the second conductive contact 162. Materials thereof may be the same as that described in the foregoing embodiments, and details are not described herein again.

In this embodiment of this application, after the first electrode 111 of the transistor and the first electrode 411 of the virtual transistor are formed, forming the plurality of memory arrays 1 further includes the following steps.

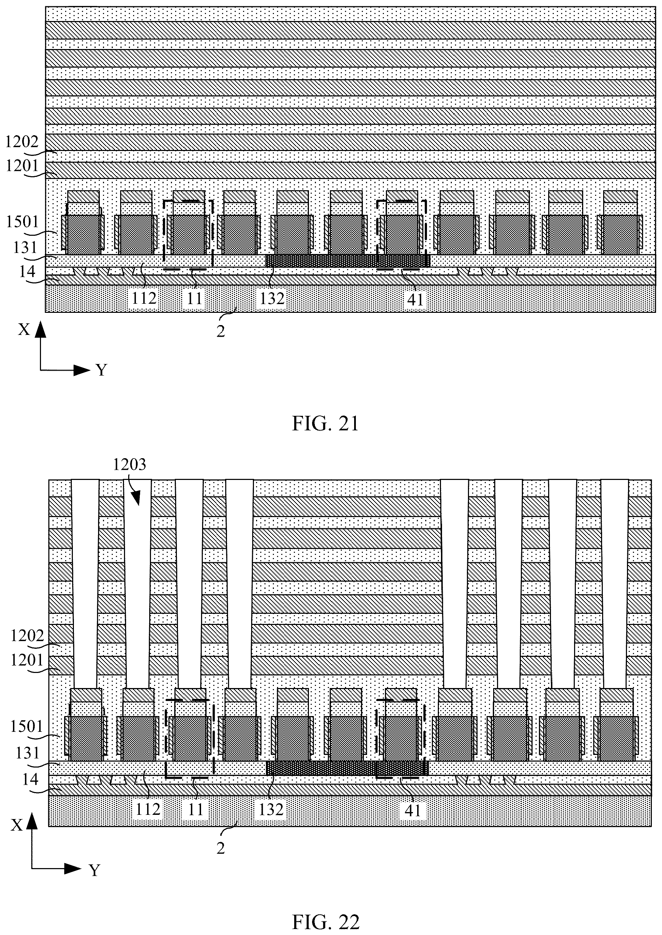

FIG. 21 is a diagram of an example of a structure of forming a conducting layer 1201 and a dielectric layer in a memory 01 preparation method according to an embodiment of this application. As shown in FIG. 21, a plurality of dielectric layers 1202 and a plurality of conducting layers 1201 are alternately stacked. Materials of the dielectric layers 1202 and the conducting layers 1201 may be described in the foregoing embodiments, and details are not described herein again.

A quantity of dielectric layers 1202 may be equal to a quantity of conducting layers 1201. It may be understood that, the quantity of dielectric layers 1202 and the quantity of conducting layers 1201 may be correspondingly adjusted based on a quantity of capacitors 12 in a memory cell 10. For example, for a memory cell 10 corresponding to a 1T3C structure, three dielectric layers 1202 and three conducting layers 1201 may be stacked.

FIG. 22 is a diagram of an example of a structure of forming a through hole 1203 in a memory 01 preparation method according to an embodiment of this application. As shown in FIG. 22, the through hole 1203 that passes through a plurality of dielectric layers 1202 and a plurality of conducting layers 1201 is formed. For example, the through hole 1203 may pass through to the first conductive contact 161. A quantity of through holes 1203 may be the same as a quantity of transistors 11, and one through hole 1203 is directly opposite to one transistor 11.

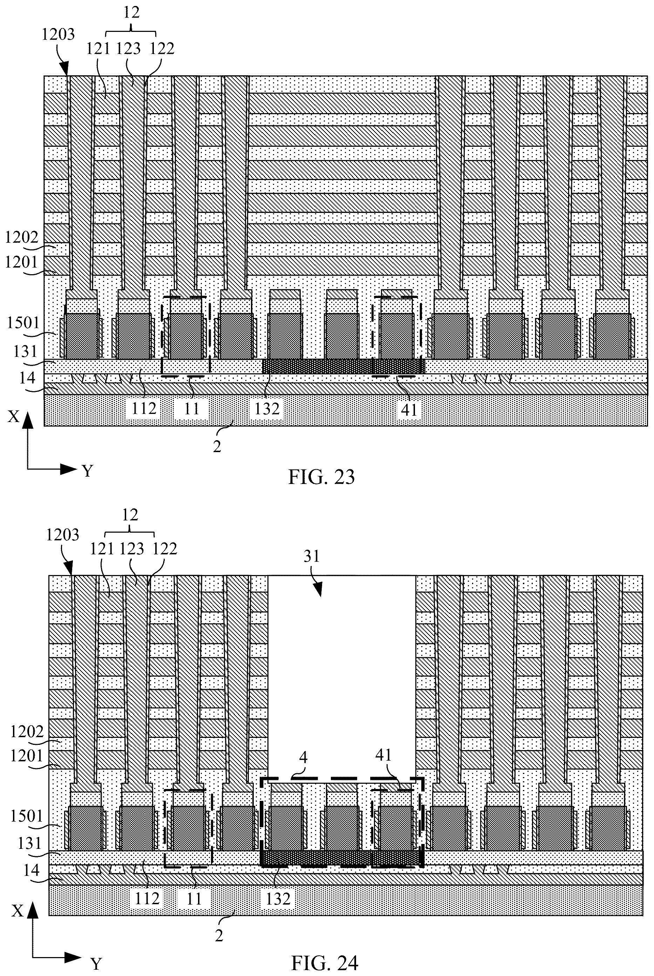

FIG. 23 is a diagram of an example of a structure of forming a capacitor 12 in a memory 01 preparation method according to an embodiment of this application. As shown in FIG. 23, a through hole 1203 is sequentially filled with a capacitor material and an electrode material, to form a capacitor layer 122 and a capacitor electrode in the through hole 1203, where the capacitor layer 122 is located between the capacitor electrode and a side wall of the through hole 1203, the capacitor electrode is a shared second capacitor electrode 123 of a plurality of capacitors 12, and at least a part of the conducting layers 1201 that surround a periphery of the capacitor layer 122 is a first capacitor electrode 121 of the capacitor 12.

In conclusion, with reference to FIG. 10, the memory array 1 is constituted by the plurality of transistors 11 and the plurality of capacitors 12 in the foregoing steps, and the filling structure 4 is disposed between two memory arrays 1, to increase structure density of an isolation region N1, thereby reducing a difference between structure density of an edge region N2 of the memory array 1 and the structure density of the isolation region N1. In this way, during the preparation process, a process defect of a film layer structure in the edge region N2 of the memory array 1 can be mitigated, thereby mitigating a performance degradation phenomenon of the transistor 11 in the edge region N2 of the memory array 1.

S103: Form an isolation spacer, where the isolation spacer is located on a side that is of the filling structure and that is away from the substrate, and in the direction parallel to the substrate, the isolation spacer is located between the two adjacent memory arrays.

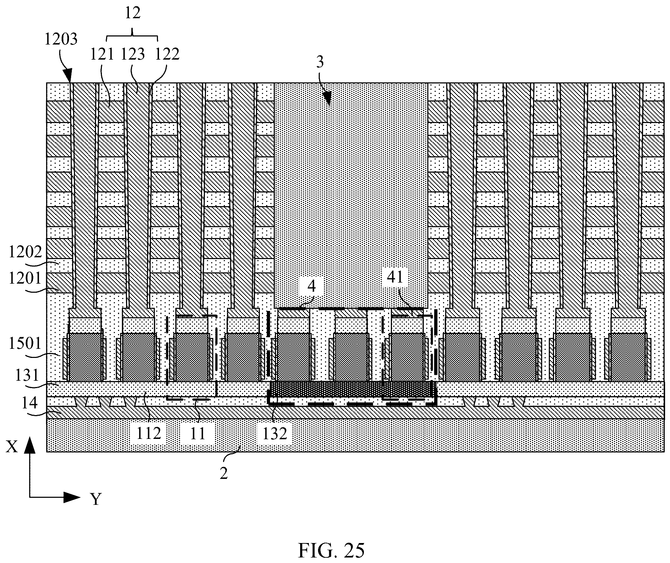

The following describes a specific process procedure related to step S103 with reference to FIG. 24 and FIG. 25. In this embodiment of this application, forming the isolation spacer 3 after forming the plurality of dielectric layers 1202 and the plurality of conducting layers 1201 that are alternately stacked includes the following steps.

FIG. 24 is a diagram of an example of a structure of forming a filling space 31 in a memory 01 preparation method according to an embodiment of this application. As shown in FIG. 24, the filling space 31 that passes through a plurality of dielectric layers 1202 and a plurality of conducting layers 1201 is formed. The filling space 31 may pass through to a second conductive contact 162, and the filling space 31 may be directly opposite to a virtual transistor 41, that is, located between two memory arrays 1. The filling space 31 is a slit (slit).

FIG. 25 is a diagram of an example of a structure of forming an isolation spacer 3 in a memory 01 preparation method according to an embodiment of this application. As shown in FIG. 25, the filling space 31 is filled with an isolation material, to form the isolation spacer 3. The filled insulating material may be, for example, one of silicon nitride, silicon oxide, and silicon oxynitride, or a combination thereof.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A memory, comprising:
a substrate;
a plurality of memory arrays, wherein the plurality of memory arrays are located on the substrate, the memory array comprises a plurality of memory cells, the memory cell comprises a transistor and at least one capacitor that are stacked in a first direction, the at least one capacitor is electrically connected to a side that is of the transistor and that is away from the substrate, and the first direction is perpendicular to the substrate;
a filling structure, located on the substrate, wherein in a direction parallel to the substrate, the filling structure is located between transistors of two adjacent memory arrays; and
an isolation spacer, located on a side that is of the filling structure and that is away from the substrate, wherein in the direction parallel to the substrate, the isolation spacer is located between capacitors of the two adjacent memory arrays.

2. The memory according to claim 1, wherein
the filling structure comprises a virtual transistor, at least a part of film layers of the virtual transistor and at least a part of film layers of the transistor are disposed at a same layer, and the virtual transistor and the transistor are spaced from each other.

3. The memory according to claim 2, wherein
a first electrode of the transistor and a second electrode of the transistor are disposed in the first direction, the first electrode of the transistor is electrically connected to the at least one capacitor, a channel layer of the transistor is located between the first electrode of the transistor and the second electrode of the transistor, and a gate of the transistor surrounds the channel layer of the transistor;
a first electrode of the virtual transistor and a second electrode of the virtual transistor are disposed in the first direction, the first electrode of the virtual transistor is connected to the isolation spacer, a channel layer of the virtual transistor is located between the first electrode of the virtual transistor and the second electrode of the virtual transistor, and a gate of the virtual transistor surrounds the channel layer of the virtual transistor; and
the first electrode of the transistor and the first electrode of the virtual transistor are disposed at a same layer, the channel layer of the transistor and the channel layer of the virtual transistor are disposed at a same layer, and the gate of the transistor and the gate of the virtual transistor are disposed at a same layer.

4. The memory according to claim 3, wherein
the plurality of memory cells are spaced from each other in a second direction, the plurality of memory cells are spaced from each other in a third direction, the second direction and the third direction are both perpendicular to the first direction, and the second direction intersects with the third direction;
the memory further comprises a plurality of conducting wires that are spaced from each other in the third direction, an extension direction of the conducting wire is parallel to the second direction, the conducting wire comprises a conducting portion and a dielectric portion that are alternately disposed in the second direction, the conducting portion and the second electrode of the transistor are disposed at a same layer and in contact, and the dielectric portion and the second electrode of the virtual transistor are disposed at a same layer and in contact; and
the memory further comprises a plurality of bit lines that are spaced from each other in the third direction, the bit line is located between the conducting wire and the substrate, an extension direction of the bit line is parallel to the second direction, and the bit line is electrically connected to the conducting portion of the conducting wire.

5. The memory according to any one of claims 2 to 4, wherein
the plurality of memory cells are spaced from each other in the second direction, the plurality of memory cells are spaced from each other in the third direction, the second direction and the third direction are both perpendicular to the first direction, and the second direction intersects with the third direction; and
there are a plurality of virtual transistors between the two adjacent memory arrays, the plurality of virtual transistors are spaced from each other in the third direction, and the virtual transistors and a plurality of transistors arranged in the second direction are spaced from each other in the second direction.

6. The memory according to claim 5, wherein
a row of virtual transistors arranged in the third direction constitute a virtual transistor group, there are a plurality of virtual transistor groups between the two adjacent memory arrays, and the plurality of virtual transistor groups are spaced from each other in the second direction.

7. The memory according to claim 6, wherein
a distance between the virtual transistor and the transistor that are arranged in the second direction and that are adjacent to each other is equal to a distance between two transistors that are arranged in the second direction and that are adjacent to each other.

8. The memory according to claim 7, wherein
a distance between two virtual transistors that are arranged in the second direction and that are adjacent to each other is equal to the distance between the two transistors that are arranged in the second direction and that are adjacent to each other.

9. The memory according to claim 7 or 8, wherein
the memory further comprises a plurality of word lines that are spaced from each other in the second direction, an extension direction of the word line is parallel to the third direction, at least one word line is electrically connected to gates of the plurality of transistors arranged in the third direction, and at least one word line is electrically connected to gates of the plurality of virtual transistors arranged in the third direction.

10. The memory according to claim 1, wherein the filling structure comprises a support block, and a material of the support block comprises an insulating material.

11. The memory according to any one of claims 1 to 10, wherein the memory further comprises an insulating portion, the insulating portion is located between the filling structure and the memory array, the insulating portion is further located between the isolation spacer and the memory array, and the insulating portion and the filling structure are made of different materials.

12. The memory according to any one of claims 1 to 11, wherein the capacitor is a ferroelectric capacitor.

13. A memory preparation method, comprising:
providing a substrate;
forming a plurality of memory arrays and a filling structure, wherein the plurality of memory arrays and the filling structure are all located on the substrate, the memory array comprises a plurality of memory cells, the memory cell comprises a transistor and at least one capacitor that are stacked in a first direction, the at least one capacitor is electrically connected to a side that is of the transistor and that is away from the substrate, the first direction is perpendicular to the substrate, and in a direction parallel to the substrate, the filling structure is located between two adjacent memory arrays; and
forming an isolation spacer, wherein the isolation spacer is located on a side that is of the filling structure and that is away from the substrate, and in the direction parallel to the substrate, the isolation spacer is located between the two adjacent memory arrays.

14. The memory preparation method according to claim 13, wherein after providing the substrate and before forming the plurality of memory arrays and the filling structure, the preparation method further includes:
forming a plurality of bit lines that are spaced from each other in a third direction and a plurality of intermediate conducting wires that are spaced from each other in the third direction, wherein the intermediate conducting wire is located on a side that is of the bit line and that is away from the substrate, extension directions of the bit line and the intermediate conducting wire are parallel to a second direction, the second direction and the third direction are both perpendicular to the first direction, and the second direction intersects with the third direction;
removing a part of the intermediate conducting wires to form a plurality of grooves that are spaced from each other, wherein the intermediate conducting wire between adjacent grooves constitutes a conducting portion;
forming a dielectric portion in the groove, wherein a plurality of dielectric portions and a plurality of conducting portions that are alternately disposed in the second direction constitute a conducting wire; and
forming a plurality of word lines that are spaced from each other in the second direction, wherein the word line is located on a side that is of the conducting wire and that is away from the substrate, and an extension direction of the word line is parallel to the third direction.

15. The memory preparation method according to claim 14, wherein the filling structure comprises a virtual transistor;
when the plurality of conducting portions are formed, a second electrode of the transistor is further formed;
when the dielectric portion is formed in the groove, a second electrode of the virtual transistor is further formed; and
when the plurality of word lines that are spaced from each other in the second direction are formed, a metal gate of the transistor and a metal gate of the virtual transistor are further formed.

16. The memory preparation method according to claim 15, wherein after forming the plurality of word lines that are spaced from each other in the second direction, forming the plurality of memory arrays and the filling structure further comprises:
forming a first channel hole and a second channel hole that pass through the word line;
filling the first channel hole and the second channel hole with a gate medium material and a channel material, to form a gate medium layer of the transistor and a channel layer of the transistor in the first channel hole, and form a gate medium layer of the virtual transistor and a channel layer of the virtual transistor in the second channel hole, wherein the metal gate of the transistor and the gate medium layer of the transistor constitute a gate of the transistor, a gate of the virtual transistor surrounds the channel layer of the virtual transistor, the metal gate of the virtual transistor and the gate medium layer of the virtual transistor constitute the gate of the virtual transistor, and the gate of the virtual transistor surrounds the channel layer of the virtual transistor; and
forming a first electrode of the transistor and a first electrode of the virtual transistor, wherein the first electrode of the transistor is located on a side that is of the channel layer of the transistor and that is away from the substrate, and the first electrode of the virtual transistor is located on a side that is of the channel layer of the virtual transistor and that is away from the substrate.

17. The memory preparation method according to claim 16, wherein after the gate of the transistor and the gate of the virtual transistor are formed, forming the plurality of memory arrays further comprises:
forming a plurality of dielectric layers and a plurality of conducting layers that are alternately stacked;
forming a through hole that passes through the plurality of dielectric layers and the plurality of conducting layers; and
sequentially filling the through hole with a capacitor material and an electrode material, to form a capacitor layer and a capacitor electrode in the through hole, wherein the capacitor layer is located between the capacitor electrode and a side wall of the through hole, the capacitor electrode is a shared second capacitor electrode of a plurality of capacitors, and at least a part of the conducting layers that surround a periphery of the capacitor layer is a first capacitor electrode of the capacitor.

18. The memory preparation method according to claim 17, wherein after forming the plurality of dielectric layers and the plurality of conducting layers that are alternately stacked, forming the isolation spacer comprises:
forming a filling space that passes through the plurality of dielectric layers and the plurality of conducting layers; and
filling the filling space with an isolation material to form the isolation spacer.

19. An electronic device, comprising:
a processor; and
the memory according to any one of claims 1 to 12, or the memory prepared by using the memory preparation method according to any one of claims 13 to 18, wherein the memory is electrically connected to the processor.
